**Europäisches Patentamt**

**European Patent Office**

**Office européen des brevets**

(19)

(11) Veröffentlichungsnummer: **0 064 719**
**B1**

# (12) EUROPÄISCHE PATENTSCHRIFT

(45) Veröffentlichungstag der Patentschrift:
**10.08.88**

(21) Anmeldenummer: **82103782.7**

(22) Anmeldetag: **03.05.82**

(51) Int. Cl.⁴: **H 01 L 31/10,** H 01 L 29/74

(54) **Lichtzündbarer Thyristor mit steuerbaren Emitter-Kurzschlusspfaden und Verfahren zu seinem Betrieb.**

(30) Priorität: **08.05.81 DE 3118318**

(43) Veröffentlichungstag der Anmeldung:
**17.11.82 Patentblatt 82/46**

(45) Bekanntmachung des Hinweises auf die Patenterteilung:
**10.08.88 Patentblatt 88/32**

(84) Benannte Vertragsstaaten:
**CH FR GB IT LI SE**

(56) Entgegenhaltungen:
**EP-A-0 029 163**
**EP-A-0 064 718**
**DE-A-2 947 669**
**DE-B-2 625 917**

(73) Patentinhaber: **Siemens Aktiengesellschaft Berlin und München, Wittelsbacherplatz 2, D-8000 München 2 (DE)**

(72) Erfinder: **Stoisiek, Michael, Dr., Robert- Koch-Strasse 24, D-8012 Ottobrunn (DE)**

EP 0 064 719 B1

**Beschreibung**

Aus der DE-C-26 25 917 ist ein lichtzündbarer Thyristor mit einem Halbleiterkörper bekannt, der einen von einer ersten Elektrode kontaktierten n-Emitter mit einer angrenzenden p-Basisschicht und einen von einer zweiten Elektrode kontaktierten p-Emitter mit einer angrenzenden n-Basisschicht aufweist, und mit an dem n(p)-Emitter innerhalb eines lateralen, lichtaktiven Halbleiterbereichs angeordneten, gategesteuerten MIS-Strukturen, die steuerbare Emitter-Kurzschlußpfade enthalten, letztere jeweils bestehend aus einem mit der ersten (zweiten) Elektrode verbundenen Halbleitergebiet eines ersten Leitungstyps, einem mit einer Basisschicht verbundenen zweiten Halbleitergebiet des ersten Leitungstyps und einem zwischen diesen Halbleitergebieten liegenden Halbleiterbereich eines zweiten Leitungstyps, der von einem gegenüber dem Halbleiterkörper elektrisch isolierten Gate überdeckt ist, wobei das erste Halbleitergebiet des steuerbaren Emitter-Kurzschlußpfades aus einem Randbereich des n(p)-Emitters besteht und das zweite Halbleitergebiet aus einem Kurzschlußgebiet gebildet ist, das in die an den n(p)-Emitter angrenzende Basisschicht eingefügt und über eine leitende Belegung mit demselben verbunden ist, und wobei der von einem Gate überdeckte Halbleiterbereich aus einem Teilbereich dieser Basisschicht besteht.

In der EP-A-00 29 163, die gemäß Artikel 54 (3) EPÜ zum Stand der Technik gehört, ist andererseits ein lichtzündbarer Thyristor mit einem Halbleiterkörper beschrieben, der einen von einer ersten Elektrode kontaktierten n-Emitter mit einer angrenzenden p-Basisschicht und einen von einer zweiten Elektrode kontaktierten p-Emitter mit einer angrenzenden n-Basisschicht aufweist, und mit an dem n(p)-Emitter innerhalb eines lateralen lichtaktiven Halbleiterbereichs angeordneten, gategesteuerten MIS-Strukturen, die steuerbare Emitter-Kurzschlußpfade enthalten, letztere jeweils bestehend aus einem mit der ersten (zweiten) Elektrode verdbundenen Halbleitergebiet eines ersten Leitungstyps, einem mit einer Basisschicht verbundenen zweiten Halbleitergebiet des ersten Leitungstyps und einem zwischen diesen Hableitergebieten liegenden Halbleiterberich eines zweiten Leitungstyps, der von einem gegenüber dem Halbleiterkörper elektrisch isolierten Gate überdeckt ist. Dabei ist eine steuerbare Lichtquelle (Lumineszenzdiode, Laserdiode oder dergl.) vorgesehen, die über einen Lichtleiter mit einem Teil der Oberfläche des Halbleiterkörpers in optischem Kontakt steht, wobei die gategesteuerten MIS-Strukturen einen gemeinsamen Steueranschluß haben, der mit dem Ausgang eines optoelektronischen Wandlers verbunden ist, welcher mit der gesteuerten Lichtquelle in optischem Kontakt steht. Zum Unterschied von dem eingangs beschriebenen, bekannten, lichtzündbaren Thyristor ist jedoch hier das erste Halbleitergebiet des steuerbaren Emitter-Kurzschlußpfades in eine Randzone des n(p)-Emitters derart eingefügt, daß es sich bis zur Grenzfläche des Halbleiterkörpers erstreckt und in dieser mit der ersten (zweiten) Elektrode leitend verbunden ist, während das zweite Halbleitergebiet des ersten Leitungstyps aus einer Zone der p-Basisschicht (n-Basisschicht) besteht, die sich bis an die Grenzfläche erstreckt, und der von einem Gate überdeckte Halbleiterbereich aus einem Teil des n-Emitters (p-Emitters) gebildet ist.

Der vorliegenden Erfindung liegt die Aufgabe zugrunde, eine einfache und leicht herzustellende Ausführungsform eines lichtzündbaren Thyristors anzugeben, der MIS-Strukturen aufweist, die entsprechend denen bei dem eingangs genannten, bekannten lichtzündbaren Thyristor ausgebildet sind, wobei eine automatische Ansteuerung dieser MIS-Strukturen erfolgt. Diese Aufgabe wird durch eine Ausbildung des Thyristors nach den Merkmalen des Patentanspruchs 1 gelöst.

Der mit der Erfindung erzielbare Vorteil besteht insbesondere darin, daß die Herstellung der für die automatisch steuerbaren Emitter-Kurzschlußpfade erforderlichen Halbleitergebiete im Rahmen derjenigen Dotierungsschritte erfolgt, die bereits zur Herstellung der einzelnen Halbleitergebiete bzw. -schichten des Thyristors benötigt werden, so daß der Mehraufwand für die automatisch steuerbaren Emitter-Kurzschlußpfade sehr klein gehalten werden kann.

Aus der US-A-3 243 669, vgl. insbesondere Fig. 9, sind Thyristoren mit steuerbaren Emitter-Kurzschlußpfaden bekannt, die lediglich zum Zweck eines schnellen Löschens der Thyristoren wirksam geschaltet werden.

Die Ansprüche 2 bis 6 betreffen Weiterbildungen des lichtzündbaren Thyristors nach der Erfindung, während der Anspruch 7 ein Verfahren zum Betrieb eines erfindungsgemäßen Thyristors angibt.

Nachfolgend wird die Erfindung näher erläutert. Dabei zeigen:

Fig. 1 ein erstes Ausführungsbeispiel der Erfindung,

Fig. 2 ein Spannungs-Zeit-Diagramm zur Erläuterung von Fig. 1,

Fig. 3 eine Teilschaltung von Fig. 1 und

Fig. 4 ein zweites Ausführungsbeispiel der Erfindung.

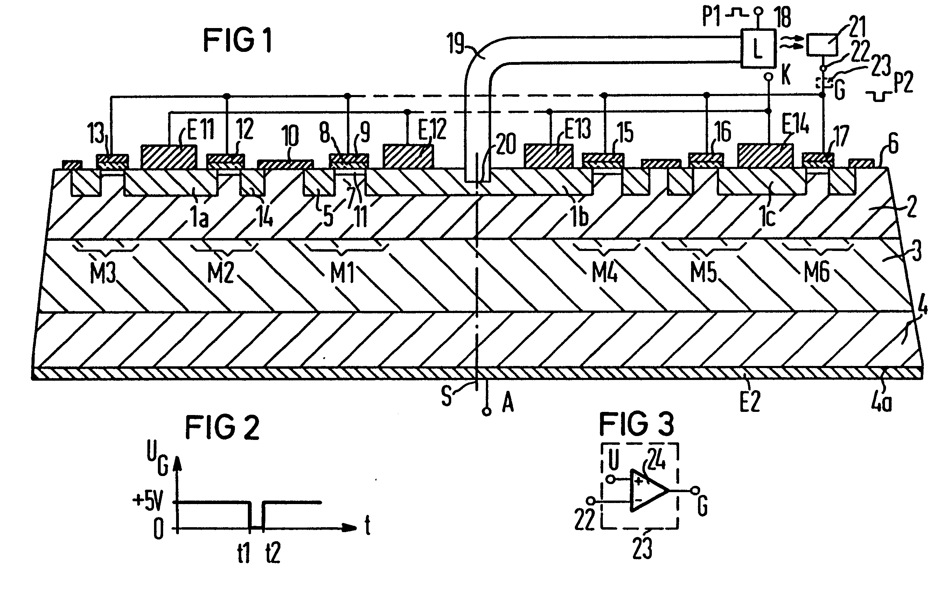

In Fig. 1 ist ein lichtzündbarer Thyristor mit einem Körper aus dotiertem Halbleitermaterial, z. B. Silizium, dargestellt, der vier aufeinanderfolgende Schichten abwechselnder Leitungstypen aufweist. Eine aus den Teilen 1a, 1b und 1c bestehende n-leitende Schicht bezeichnet man als den n-Emitter, eine p-leitende Schicht 2 als die p-Basisschicht, eine n-leitende Schicht 3 als die n-Basisschicht und eine p-leitende Schicht 4 als den p-Emitter. Die Teile 1a bis 1c des n-Emitters werden in der Grenzfläche 6 des Halbleiterkörpers von Teilen E11 bis E14 einer ersten Elektrode (Kathode) kontaktiert, die mit einem gemeinsamen Anschluß K verbunden sind. Die Teile E11 bis E14 bestehen aus einem elektrisch leitenden Material, z. B. Alumium. Der p-Emitter 4 wird in der gegenüberliegenden Grenzfläche 4a des Halbleiterkörpers von einer zweiten Elektrode (Anode) E2 aus einem elektrisch leitenden Material, z.B. Aluminium, kontaktiert, die mit einem Anschluß A verbunden ist.

Der Halbleiterkörper des Thyristors nach Fig. 1 weist die Form einer flachen, insbesondere runden Scheibe auf, während die Teile 1a bis 1c des n-Emitters jeweils streifenförmige, langgestreckte Halbleitergebiete darstellen, die im wesentlichen senkrecht zur Bildebene von Fig. 1 über den gesamten Thyristorquerschnitt oder über Teile davon verlaufen.

Am linken Rand des n-Emitterteils 1b ist ein n-leitendes Kurzschlußgebiet 5 in die p-Basisschicht 2 eingefügt, das sich bis zur Grenzfläche 6 des Halbleiterkörpers erstreckt. Es weist einen Abstand von dem n-Emitterteil 1b auf, der durch die Breite eines Teilbereiches 7 der p-Basisschicht 2 bestimmt ist. Der Teilbereich 7 wird von einer auf der Grenzfläche 6 aufgebrachten, dünnen, elektrisch isolierenden Schicht 8 überdeckt, auf der ein Gate 9 aus elektrisch leitendem Material, z. B. aus hochdotiertem polykristallinen Silizium oder aus Metall, insbesondere Aluminium, aufgebracht ist. Das Gate 9 ist mit einem Steueranschluß G verbunden. Der linke Rand des Kurzschlußgebiets 5 wird von einer leitenden Belegung 10 kontaktiert, die den dort befindlichen pn-Übergang zwischen den Teilen 5 und 2 niederohmig überbrückt.

Die linke Randzone des n-Emitterteils 1b bildet ein erstes n-leitendes Halbleitergebiet einer MIS-Struktur M1, zu der weiterhin das Kurzschlußgebiet 5 als zweites n-leitendes Halbleitergebiet und der Teilbereich 7 als p-leitendes Halbleitergebiet sowie die Teile 8 und 9 gehören. Handelt es sich bei M1 um eine Struktur des Verarmungstyps, so ist bei spannungslosem Gate 9 ein die Teile 1b und 5 niederohmig verbindender n-leitender Kanal 11 vorhanden. Der Kanal 11 kann z. B. aus einer Inversionsschicht bestehen, die durch ein an der Grenzfläche 6 oberhalb des Bereiches 7 herrschendes elektrisches Feld aufgebaut worden ist, oder kann durch unmittelbar an der Grenzfläche 6 in den Bereich 7 eingefügte zusätzliche n-Dotierung gebildet sein. Die Teile 11 und 5 bilden in Verbindung mit der leitenden Belegung 10 einen Emitter-Kurzschlußpfad, der die Teile 1b und 2 niederohmig miteinander verbindet. Führt man dem Anschluß G eine negative Steuerspannung zu, so wird der Kanal 11 aufgehoben bzw. hochohmig geschaltet, so daß der genannte Emitter-Kurzschlußpfad abgeschaltet ist. Eine zweite, entsprechend aufgebaute MIS-Struktur M2 ist am rechten Rand des n-Emitterteils 1a vorgesehen sowie eine dritte, entsprechend aufgebaute MIS-Struktur M3 am linken Rad von 1a. Die Gates 12 und 13 von M2 und M3 sind ebenfalls an den Anschluß G geführt. Die leitende Belegung 10 ist in Fig. 1 soweit nach links verlängert, daß sie auch das Kurzschlußgebiet 14 von M2 kontaktiert und somit den pn-Übergang zwischen den Teilen 14 und 2 am rechten Rad von 14 niederohmig überbrückt.

Der Aufbau des Thyristors nach Fig. 1 ist symmetrisch zu einer Symmetrieebene, die auf die Bildebene von Fig. 1 senkrecht steht und durch eine strichpunktierte Linie S angedeutet ist. Den Strukturen M1 bis M3 entsprechen weitere Strukturen M4 bis M6 in der rechten Hälfte von Fig. 1. Die Gates 15 bis 17 dieser Strukturen sind auch mit dem Anschluß G verbunden.

Eine steuerbare Lichtquelle L, insbesondere eine Lumineszenzdiode, Laserdiode oder dergleichen, wird über einen Steuereingang 18 mit einem Stromimpuls P1 beaufschlagt, der eine Bestrahlung eines Teils des Halbleiterkörpers durch einen von L ausgehenden und über den Lichtleiter 19, z. B. einen Glasfaser-Lichtleiter, übertragenen Lichtstrahl bewirkt.

Im Betrieb liegt ein äußerer Laststromkreis an den Anschlüssen A und K, der die Serienschaltung einer Spannungsquelle und eines Lastwiderstandes enthält. Legt diese Spannungsquelle den Anschluß A auf ein positiveres Potential als K, so befindet sich der Thyristor nach Fig. 1 zunächst im blockierten Zustand, in dem kein nennenswerter Laststrom zwischen A und K fließt. Die in der Basisschicht 2 thermisch generierten Defektelektronen werden über die bei spannungslo sem Anschluß G wirksam geschalteten Emitter-Kurzschlußpfade, z. B. 11, 5, 10, der Strukturen M1 bis M6 zu den Teilen E11 bis E14 der Kathode abgeleitet, so daß aus den n-Emitterteilen 1a bis 1c keine Ladungsträgerinjektion in die Basisschicht 2 erfolgt, die zur Zündung führen würde.

Um den Thyristor zu zünden, wird dem Steuereingang 18 ein Stromimpuls P1 zugeführt. Zur gleichen Zeit wird dem Steueranschluß G ein die n-Kanäle, z. B. 11, 5, 10, der Strukturen M1 bis M6 abschaltender, negativer Spannungsimpuls P2 zugeführt. Hierdurch werden unterhalb des Endes 20 des Lichtleiters 19 durch die Lichteinwirkung in der Basisschicht 2 Ladungsträger erzeugt, die zusammen mit thermisch generierten Ladungsträgern zum pn-Übergang des im lichtaktiven Halbleiterbereich liegenden n-Emitterteils 1b gelangen und eine Injektion von Ladungsträgern aus diesem in die Basisschicht 2 veranlassen. Damit zündet der Thyristor auch bei kleinen Lichtleistungen der Lichtquelle L. Von 1b ausgehend breitet sich der gezündete Teil des Thyristors wegen der unwirksam geschalteten Emitter-Kurzschlußpfade sehr rasch auf die äußeren Bereiche des Thyistorquerschnitts aus, in denen die n-Emitterteile 1a und 1c angeordnet sind, so daß der Laststrom des angeschlossenen Laststromkreises sehr schnell von dem gesamten Thyrtistorquerschnitt aufgenommen wird. Die Abschaltung des Thyristors erfolgt dann, wenn der Laststrom einen Haltewert unterschreitet, was beispielsweise durch eine Unterbrechung des Laststromkreises erfolgt oder, wenn es sich bei der Spannungsquelle im Laststromkreis um eine Wechselspannungsquelle handelt, durch den nachfolgenden Nulldurchgang der Wechselspannung.

In einigen Anwendungsfällen kann es erwünscht sein, MIS-Strukturen M1 bis M6 des Anreicherungstyps zu verwenden. Hierbei muß der Anschluß G im Gegensatz zu der bisher beschriebenen Ansteuerung ständig mit einer gegenüber dem Anschluß K positiven Spannung beschaltet sein, durch die in M1 bis M6 n-leitende Inversionskanäle aufgebaut werden, wobei diese positive Spannung lediglich für die Dauer des Zündvorgangs abgeschaltet wird.

Mit Vorteil ist ein optoelektronischer Wandler 21, z. B. eine Fotodiode, vorgesehen, der mit der gesteuerten Lichtquelle L in optischem Kontakt steht. Am Ausgang 22 des Wandlers 21 kann der Impuls P2 unmittelbar abgegriffen werden, so daß bei einer Verbindung des Ausgangs 22 mit dem Anschluß G eine automatische Ansteuerung der MIS-Strukturen M1 bis M6 des Verarmungstyps erfolgt.

Handelt es sich bei M1 bis M6 um Strukturen des Anreicherungstyps, so ist eine Zusatzschaltung 23 zwischen

3

den Anschlüssen 22 und G vorzusehen, die aus einem an 22 abgreifbaren negativen Spannungsimpuls, der während des Zündvorgangs auftritt, eine Steuerspannung $U_G$ ableitet, die dem Steueranschluß G zugeführt wird. Die Steuerspannung $U_G$, deren zeitlicher Verlauf in Fig. 2 dargestellt ist, weist im blockierten Zustand des Thyristors eine Amplitude von z. B. +5V auf, die ausreicht, um n-leitende Inversionskanäle 11 aufzubauen. Während des Zündvorgangs, der im Zeitintervall t1 bis t2 abläuft, ist $U_G$ dann abgeschaltet. Die Zusatzschaltung 23 besteht zweckmäßigerweise gemäß Fig. 3 aus einem Differenzverstärker 24, dessen positiver Eingang mit einer Spannung U beschaltet ist, die der Amplitude des bei 22 abgreifbaren negativen Impulses entspricht und beispielsweise +5V beträgt, während der negative Eingang von 24 mit dem Ausgang 22 beschaltet ist und der Ausgang von 24 am Anschluß G liegt.

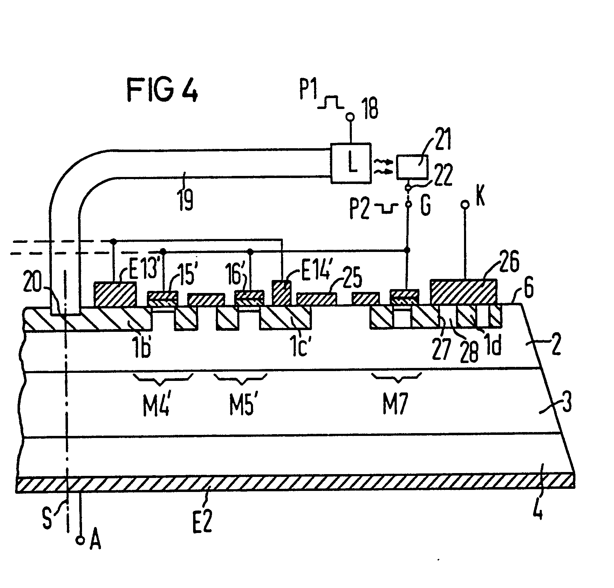

In Fig. 4 ist ein anderes Ausführungsbeispiel der Erfindung dargestellt, das n-Emitterteile 1b' und 1c' aufweist, die mit Teilen E13' und E14' einer ersten Elektrode belegt sind. Randseitig zu den Teilen 1b' und 1c' sind MIS-Strukturen M4' und M5' vorgesehen, deren Gates mit 15' und 16' bezeichnet sind. Diese Schaltungsteile entsprechen weitgehend den Teilen 1b, 1c, E13, E14, M4, M5, 15 und 16 von Fig. 1. Zum Unterschied von diesen sind die Teile E13' und E14' zwar untereinander, jedoch nicht mit dem Anschluß K verbunden. Außerdem tritt an die Stelle der MIS-Struktur M6 von Fig. 1 eine leitende Belegung 25, die in Fig. 4 den pn-Übergang am rechten Rand des n-Emitterteils 1c' niederohmig überbrückt. Infolge dieser Abänderungen stellen die n-Emitterteile 1b' und 1c' einen sog. Hilfsemitter dar, während die Elektrodenteile E13' und E14' zusammen mit der leitenden Belegung 25 eine Hilfsemitterelektrode (amplifying gate) bilden. Weiterhin ist in Fig. 4 ein n-Emitterteil 1d vorgesehen, der den Hauptemitter des Thyristors bildet. Dieser ist mit einer Kathode 26 aus elektrisch leitendem Material, z. B. aus hochdotiertem polykristallinen Silizium oder aus Metall, z. B. Aluminium, versehen, die mit dem Anschluß K verbunden ist. Die übrigen Schaltungsteile von Fig. 4 entsprechen den gleichbezeichneten Teilen von Fig. 1 nach Aufbau und Wirkungsweise. Der n-Emitterteil 1d ist an seinem linken Rand mit einer MIS-Struktur M7 versehen, die nach Aufbau und Wirkungsweise beispielsweise der Struktur M1 von Fig. 1 entspricht. Zweckmäßigerweise ist der n-Emitterteil 1d noch mit Ausnehmungen 27 versehen, die von Ansätzen 28 der p-Basisschicht 2 durchdrungen werden, welche in der Grenzfläche 6 von der Kathode 26 kontaktiert werden. Die Teile 27, 28 stellen sog. feste Emitterkurzschlüße dar, die die Stabilität im Bereich des Hauptemitters 1d erhöhen.

Im blockierten Zustand des Thyristors nach Fig. 4 sind die Emitter-Kurzschlußpfade in den Strukturen M4', M5' und M7 wirksam geschaltet, was bei einer Ausbildung dieser Strukturen als solche des Verarmungstyps entsprechend Fig. 1 bei spannungslosem Steueranschluß G der Fall ist. Zum Zünden des Thyristors führt man dem Anschluß 18 einen Stromimpuls P1 zu, während der Steueranschluß G gleichzeitig mit einem negativen Spannungsimpuls P2 beaufschlagt wird. Hierdurch wird wieder einerseits der lichtaktive Bereich unterhalb des Endes 20 des Lichtleiters 19 aus der steuerbaren Lichtquelle L angestrahlt, während gleichzeitig die Emitter-Kurzschlußpfade in den Strukturen M4', M5' und M7 aufgehoben bzw. abgeschaltet werden. Damit zündet der Thyristor nach Fig. 4 bei kleinen Lichtleistungen der Lichtquelle L zunächst im Bereich des Hilfsemitters 1b' und 1c'. Der über den Hilfsemitter fließende Strom wird über die leitende Belegung 25 in Richtung auf den Hauptemitter 1d umgelenkt und stellt einen großen Zündstrom für diesen Thyristorteil dar, der zu einer schnellen und großflächigen Zündung des Thyristorquerschnitts im Bereich des Hauptemitters 1d führt. Anschließend wird der Thyristor im Bereich des Hilfsemitters 1b', 1c' wieder gelöscht, wobei der gesamte Laststrom durch den Teil des Thyristorquerschnitts aufgenommen wird, der den Hauptemitter 1d enthält. Daher kann nach der erfolgten Zündung des gesamten Thyristorquerschnitts der Spannungsimpuls P2 von G wieder abgeschaltet werden, wobei die Emitter-Kurzschlußpfade der Strukturen M4', M5' und M7 wieder wirksam geschaltet werden, ohne daß der im Bereich des Hauptemitters 1d stattfindende Stromdurchgang hiervon beeinflußt wird.

Die Ansteuerung von G erfolgt mit Vorteil über den Ausgang 22 des optoelektronischen Wandlers 21 in der bereits anhand von Fig. 1 beschriebenen Weise. Bei MIS-Strukturen M4', M5' und M7 des Verarmungstyps können die Anschlüsse 22 und G unmittelbar miteinander verbunden werden, während bei Strukturen des Anreicherungstyps die gemäß Fig. 3 ausgebildete Zusatzschaltung 24 zwischen 22 und G eingefügt wird.

Gemäß einer weiteren Ausgestaltung der Erfindung sind die Thyristoren nach den Figuren 1 und 4 in Abweichung von der bisherigen Beschreibung rotationssymmetrisch ausgebildet. Die strichpunktierte Linie S kann hierbei als Symmetrieachse aufgefaßt werden. Die dargestellten Teilstrukturen sind dann kreisringförmig ausgebildet, wobei die gestrichelt dargestellten horizontalen Verbindungsleitungen in den Figuren 1 und 4 enfallen.

Im Rahmen der Erfindung kann auch der p-Emitter 4 anstelle des n-Emitters mit MIS-Strukturen versehen sein, die steuerbare Emitter-Kurzschlußpfade enthalten. Die Figuren 1 und 4 können zur Darstellung dieser Variante herangezogen werden, wenn die Bezeichnungen der Anschlüsse A und K miteinander vertauscht werden, die dargestellten Halbleitergebiete die jeweils entgegengesetzten Leitungstypen aufweisen und die dem Anschluß G zugeführten Spannungen bzw. Spannungsimpulse jeweils umgepolt werden.

Die Eindringtiefe der n-Emittergebiete 1a, 1b und 1c sowie der Kurzschlußgebiete, z. B. 5 und 14, in die p-Basisschicht 2 kann beispielsweise 3 µm betragen. Hierbei kommen dann für die Abstände der Kurzschlußgebiete 5 und 14 von den zugeordneten n-Emittergebieten 1b und 1a z. B. jeweils 5 µm in Betracht. Die lateralen Abmessungen der Kurzschlußgebiete 5, 14 usw. in der Bildebene von Fig. 1 können z. B. jeweils 10 µm betragen. Die Dicke des Halbleiterkörpers des Thyristors nach den Figuren 1 oder 4 liegt z. B. in einem Bereich von 200 µm bis 1 mm.

**Patentansprüche**

1. Lichtzündbarer Thyristor mit einem Halbleiterkörper, der einen von einer ersten Elektrode kontaktierten n-Emitter mit einer angrenzenden p-Basisschicht und einen von einer zweiten Elektrode kontaktierten p-Emitter mit einer angrenzenden n-Basisschicht aufweist, und mit an dem n(p)-Emitter innerhalb eines lateralen, lichtaktiven Halbleiterbereichs angeordneten, gategesteuerten MIS-Strukturen, die steuerbare Emitterkurzschlußpfade enthalten, letztere jeweils bestehend aus einem mit der ersten (zweiten) Elektrode verbundenen Halbleitergebiet eines ersten Leitungstyps, einem mit einer Basisschicht verbundenen zweiten Halbleitergebiet des ersten Leitungstyps und einem zwischen diesen Halbleitergebieten liegenden Halbleiterbereich eines zweiten Leitungstyps, der von einem gegenüber dem Halbleiterkörper elektrisch isolierten Gate überdeckt ist, wobei das erste Halbleitergebiet des steuerbaren Emitter-Kurzschlußpfades aus einem Randbereich des n(p)-Emitters (1) besteht und das zweite Halbleitergebiet aus einem Kurzschlußgebiet (5) gebildet ist, das in die an den n(p)-Emitter (1b) angrenzende Basisschicht (2) eingefügt und über eine leitende Belegung (10) mit derselben verbunden ist, wobei der von einem Gate (9) überdeckte Halbleiterbereich aus einem Teilbereich (7) dieser Basisschicht (2) besteht, wobei eine steuerbare Lichtquelle (Lumineszenzdiode, Laserdiode oder dergl. (L) vorgesehen ist, die über einen Lichtleiter (19) mit einem Teil der Oberfläche des Halbleiterkörpers in optischem Kontakt steht und wobei die gategesteuerten MIS-Strukturen (M1 bis M6) einen gemeinsamen Steueranschluß (G) haben, der direkt oder über eine Zusatzschaltung (23) mit dem Ausgang eines optoelektronischen Wandlers (21) verbunden ist, der mit der gesteuerten Lichtquelle (L) in optischem Kontakt steht.

2. Lichtzündbarer Thyristor nach Anspruch 1, dadurch gekennzeichnet, daß wenigstens eine MIS-Struktur (M1) dem Verarmungstyp angehört und ein in ihren überdeckten Halbleiterbereich (7) eingefügtes Kanalgebiet (11) des ersten Leitungstyps aufweist.

3. Lichtzündbarer Thyristor nach Anspruch 1 oder 2, dadurch gekennzeichnet, daß der n(p)-Emitter in eine Mehrzahl von streifenförmigen Emitterteilen (1a, 1b, 1c) aufgeteilt ist, die mit untereinander verbundenen Teilen der ersten (zweiten) Elektrode (E11, E12, E13, E14) versehen sind, und daß eine Mehrzahl von streifenförmig ausgebildeten MIS-Strukturen (M1 bis M6) randseitig zu den streifenförmigen n(p)-Emitterteilen (1a bis 1c) angeordnet sind.

4. Lichtzündbarer Thyristor nach einem der Ansprüche 1 bis 3, dadurch gekennzeichnet, daß die erste (zweite) Elektrode (E11 bis E14) aus einer Kathode (Anode) besteht.

5. Lichtzündbarer Thyristor nach einem der Ansprüche 1 bis 3, dadurch gekennzeichnet , daß er einen n(p)-Hilfsemitter (1b', 1c') mit einer diesen kontaktierenden Hilfsemitterelektrode und einen mit Emitterkurzschlüssen (27, 28, M7) versehenen n(p)-Hauptemitter (1d) mit einer diesen kontaktierenden Kathode (Anode) (26) aufweist und daß die erste (zweite) Elektrode (E13', E14' ) die Hilfsemitterelektrode bildet.

6. Lichtzündbarer Thyristor nach Anspruch 1, dadurch gekennzeichnet, daß die Zusatzschaltung (23) eine pegelverschiebende Funktion aufweist.

7. Verfahren zum Betrieb eines lichtzündbaren Thyristors mit einem Halbleiterkörper, der einen von einer ersten Elektrode kontaktierten n-Emitter mit einer angrenzenden p-Basisschicht und einen von einer zweiten Elektrode kontaktierten p-Emitter mit einer angrenzenden n-Basisschicht aufweist, und mit an dem n(p)-Emitter innerhalb eines lateralen, lichtaktiven Halbleiterbereichs angeordneten, gategesteuerten MIS-Strukturen, die steuerbare Emitterkurzschlußpfade enthalten, letztere jeweils bestehend aus einem mit der ersten (zweiten) Elektrode verbundenen Halbleitergebiet eines ersten Leitungstyps, einem mit einer Basisschicht verbundenen zweiten Halbleitergebiet des ersten Leitungstyps und einem zwischen diesen Halbleitergebieten liegenden Halbleiterbereich eines zweiten Leitungstyps, der von einem gegenüber dem Halbleiterkörper elektrisch isolierten Gate überdeckt ist, wobei das erste Halbleitergebiet des steuerbaren Emitter-Kurzschlußpfades aus einem Randbereich des n(p)-Emitters (1) besteht und das zweite Halbleitergebiet aus einem Kurzschlußgebiet (5) gebildet ist, das in die an den n(p)-Emitter (1b) angrenzende Basisschicht (2) eingefügt und über eine leitende Belegung (10) mit derselben verbunden ist, wobei der von einem Gate (9) überdeckte Halbleiterbereich aus einem Teilbereich (7) dieser Basisschicht (2) besteht, wobei eine steuerbare Lichtquelle (Lumineszenzdiode, Laserdiode oder dergl. (L) vorgesehen ist, die über einen Lichtleiter (19) mit einem Teil der Oberfläche des Halbleiterkörpers in optischem Kontakt steht und wobei die gategesteuerten MIS-Strukturen (M1 bis M6) einen gemeinsamen Steueranschluß (G) haben, der direkt oder über eine Zusatzschaltung (23) mit dem Ausgang eines optoelektronischen Wandlers (21) verbunden ist, der mit der gesteuerten Lichtquelle (L) in optischem Kontakt steht, dadurch gekennzeichnet, daß ein Teil der Oberfläche des Halbleiterkörpers von einer gesteuerten Lichtquelle (L) zum Zwecke der Zündung bestrahlt wird und daß über den optoelektronischen Wandler (21) von der Lichtquelle (L) ein Spannungsimpuls (P2) zur Steuerung der Emitterkurzschlußpfade (11, 5, 10) in den MIS-Strukturen (M1 bis M6) abgeleitet wird.

**Claims**

1. A light-ignitable thyristor consisting of a semiconductor body which comprises an n-doped emitter contacted by a first electrode and adjoined by a p-doped base layern, a p-doped emitter contacted by a second electrode and adjoined by an n-doped base layer, gate-controlled MIS-structures arranged on the n(p)-doped emitter within a lateral, light-active semiconductor zone, and which contains controllable emitter short-circuit paths, where each of the latter consists of a semiconductor zone of a first conductivity type connected to the first (second) electrode, a second semiconductor zone of the first conductivity type connected to a base layer, and a semiconductor zone of a second conductivity type located between the semiconductor zones and covered by a gate electrically insulated from the semiconductor body, where the first semiconductor zone of the controllable emitter short-circuit path consists of an edge zone of the n(p)-doped emitter (1), and the second semiconductor zone is formed by a short-circuit zone (5) formed in the base layer (2) which adjoins the n(p)-doped emitter (1b) and is connected thereto via a conductive covering (10), where the semiconductor zone which is covered by a gate (9) consists of a sub-zone (7) of this base layer (2), where a controllable light source (LED), laser diode or the like (L) is provided optically coupled via a light conductor (19) to a part of the surface of the semiconductor body, and where the gate-controlled MIS-structures (M1 to M6) have a common control terminal (G) which is connected either directly or via an additional circuit (23) to the output of an opto-electronic transducer (21) which is in optical contact with the controlled light source (L).

2. A light-ignitable thyristor as claimed in Claim 1, <u>characterised in that</u> at least one MIS-structure (M1) is of the depletion type and comprises a channel zone (11) of the first conductivity type interposed in its covered semiconductor zone (7).

3. A light-ignitable thyristor as claimed in Claim 1 or 2, <u>characterised in that</u> the n(p)-doped emitter is divided into a plurality of strip-shaped emitter components (1a, 1b, 1c) which are provided with components, connected to one another, of the first (second) electrode (E11, E12, E13, E14), and that a plurality of strip-shaped MIS-structures (M1 to M6) are arranged laterally to the strip-shaped n(p)-doped emitter components (1a, 1c).

4. A light-ignitable thyristor as claimed in one of Claims 1 to 3, <u>characterised in that</u> the first (second) electrode (E11 to E14) consists of a cathode (anode).

5. A light-ignitable thyristor as claimed in one of Claims 1 to 3, <u>characterised in that</u> it comprises an n(p)-doped auxiliary emitter (1b', 1c') provided with an auxiliary emitter electrode which contacts the auxiliary emitter, and an n(p)-doped main emitter (1d) provided with emitter short-circuits (27, 28, M7) and a cathode (anode) (26) which contacts the main emitter, and that the first (second) electrode (E13', E14') forms the auxiliary emitter electrode.

6. A light-ignitable thyristor a claimed in Claim 1, <u>characterised in that</u> the additional circuit (23) has a level-shifting function.

7. A method of operating a light-ignitable thyristor consisting of a semiconductor body which comprises an n-doped emitter which is contacted by a first electrode and is adjoined by a p-doped base layer, and a p-doped emitter which is contacted by a second electrode and is adjoined by an n-doped base layer, and consisting of gate-controlled MIS-structures which are arranged on the n(p)-doped emitter within a lateral, light-active semiconductor zone and which contain controllable emitter short-circuit paths, where each of the latter consists of a semiconductor zone of a first conductivity type connected to the first (second) electrode, a second semiconductor zone of the first conductivity type connected to a base layer, and a semiconductor zone of a second conductivity type arranged between the semiconductor zones and covered by a gate electrically insulated from the semiconductor body, where the first semiconductor zone of the controllable emitter short-circuit path consists of an edge zone of the n(p)-doped emitter (1) and the second semiconductor zone is formed by a short-circuit zone (5) interposed into the base layer (2), which adjoins the n(p)-doped emitter (1b), and is connected thereto via a conductive covering (10), where the semiconductor zone which is covered by a gate (9) consists of a sub-zone (7) of this base layer (2), where a controllable light source (LED, laser diode or the like) (L) is provided optically coupled via a light conductor (19) to a part of the surface of the semiconductor body, and where the gate-controlled MIS-structures (M1 to M6) have a common control terminal (G) connected either directly or via an additional circuit (23) to the output of an opto-electronic transducer (21) in optical contact with the controlled light source (L), <u>characterised in that</u> a part of the surface of the semiconductor body is irradiated by a controlled light source (L) for the purpose of ignition, and that via the opto-electronic transducer (21) a voltage pulse (P2) is derived from the light source (L) in order to control the emitter short-circuit paths (11, 5, 10) in the MIS-structures (M1 to M6).

**Revendications**

1. Thyristor amorçable par une lumière, comportant un corps semiconducteur, qui possède un émetteur de type n qui est en contact avec une première électrode et jouxte une couche de base de type p, et un émetteur de type p, qui est en contact avec une seconde électrode et jouxte une couche de base de type n, et des structures MIS commandées par la grille, qui sont disposées à côté de l'émetteur de type n(p) à l'intérieur d'une région semiconductrice latérale active sous l'action de la lumière et qui contiennent des voies de court-circuit d'émetteur commandables, qui sont constituées chacune par une région semiconductrice possédant un premier type de conductivité et reliée à une première (seconde) électrode, par une seconde région semiconductrice possédant le premier type de conductivité et reliée à une couche de base, et par une région semiconductrice possédant un second type de conductivité et située entre ces régions conductrices et qui est recouverte par une grille électriquement isolée vis-à-vis du corps semiconducteur, et dans lequel la première région semiconductrice de la voie de court-circuit d'émetteur commandable est constituée par une zone marginale de l'émetteur (1) de type n(p) et la seconde région semiconductrice est formée par une région de court-circuit (5) qui est insérée dans la couche de base (2) qui jouxte l'émetteur (1b) de type n(p) et est reliée à cette couche par l'intermédiaire d'un revêtement conducteur (10), et dans lequel la région semiconductrice recouverte par une grille (9) est constituée par une zone partielle (7) de cette couche de base (2), et dans lequel il est prévu une source de lumière commandable (diode à luminescence, diode laser ou analogue (L)), qui est en contact optique par l'intermédiaire d'un guide de lumière (19) avec une partie de la surface du corps semiconducteur, et dans lequel les structures MIS (M1 à M6) commandées par la grille possèdent une borne de commande commune (G) qui est reliée directement ou par l'intermédiaire d'un circuit additionnel (23) à la sortie d'un transducteur optoélectronique 21, qui est en contact optique avec la source de lumière commandée (L).

2. Thyristor pouvant être amorcé par la lumière suivant la revendication 1, caractérisé par le fait qu'au moins une structure MIS (M1) est du type à appauvrissement et comporte une zone de canal (11) possédant le premier type de conductivité et insérée dans sa région semiconductrice (7) recouverte.

3. Thyristor pouvant être amorcé par la lumière suivant la revendication 1 ou 2, caractérisé par le fait que l'émetteur de type n(p) est subdivisé en une multiplicité d'éléments d'émetteur en forme de bandes (1a, 1b, 1c), qui sont munis de parties, reliées entre elles, de la première (seconde) électrode (E11, E12, E13, E14) et qu'une multiplicité de structures MIS (M1 à M6) réalisées en forme de bandes sont disposées sur les bords des parties d'émetteur (1a à 1c) de type n(p) en forme de bandes.

4. Thyristor pouvant être amorcé par la lumière suivant l'une des revendications 1 à 3, caractérisé par le fait que la première (seconde) électrode (E11 à E14) est constituée par une cathode (une anode).

5. Thyristor pouvant être amorcé par la lumière suivant l'une des revendications 1 à 3, caractérisé par le fait qu'il comporte un émetteur auxiliaire (1b', 1c') de type n(p), comportant une électrode d'émetteur auxiliaire, qui est en contact avec cet émetteur, et un émetteur principal (1d) de type n(p), équipé de courts-circuits d'emetteur (27, 28, M7) et comportant une cathode (anode) (26), qui est en contact avec cet émetteur, et que la première (seconde) électrode (E13', E14') constitue l'électrode d'émetteur auxiliaire.

6. Thyristor pouvant être amorcé par la lumière suivant la revendication 1, caractérisé par le fait que le circuit additionnel (23) possède une fonction de décalage de niveau.

7. Procédé pour la mise en oeuvre d'un thyristor pouvant être amorcé par la lumière et comportant un corps semiconducteur, qui possède un émetteur de type n qui est en contact avec une première électrode et jouxte une couche de base de type p, et un émetteur de type p, qui est en contact avec une seconde électrode et jouxte une couche de base de type n, et des structures MIS commandées par la grille, qui sont disposées à côté de l'émetteur de type n(p) à l'intérieur d'une région semiconductrice latérale active sous l'action de la lumière et qui contiennent des voies de court-circuit d'émetteur commandables, qui sont constituées chacune par une région semiconductrice possédant un premier type de conductivité et reliée à une couche de base, et par une région semiconductrice possédant un second type de conductivité et située entre ces régions conductrices et qui est recouverte par une grille électriquement isolée vis-à-vis du corps semiconducteur, et dans lequel la première région semiconductrice de la voie de court-circuit d'émetteur commandable est constituée par une zone marginale de l'émetteur (1) de type n(p) et la seconde région semiconductrice est formée par une région de court-circuit (5) qui est insérée dans la couche de base (2) qui jouxte l'émetteur (1b) de type n(p) et est reliée à cette couche par l'intermédiaire d'un revêtement conducteur (10), et dans lequel la région semiconductrice recouverte par une grille (9) est constituée par une zone partielle (7) de cette couche de base (2), et dans lequel il est prévu une source de lumière commandable (diode à luminescence, diode laser ou analogue (L)), qui est en contact optique par l'intermédiaire d'un guide de lumière (19) avec une partie de la surface du corps semiconducteur, et dans lequel les structures MIS (M1 à M6) commandées par la grille possèdent une borne de commande commune (G) qui est reliée directement ou par l'intermédiaire d'un circuit additionnel (23) à la sortie d'un transducteur optoélectronique (21), qui est en contact optique avec la source de lumière commandée (L), caractérisé par le fait qu'on irradie une partie de la surface du corps semiconducteur par une source de lumière commandée (L) en vue de réaliser l'amorçage et qu'une impulsion de tension (P2) est dérivée de la source de lumière (L), par l'intermédiaire du transducteur optoélectronique (21), pour réaliser la commande des voies de court-circuit d'émetteur (11, 5, 10) dans les structures MIS (M1 à M6).

# FIG 1

P1 ⌐⌐ ○ 18

19

L

21

22

23 P2

K

13  E11  12  10  8  9  E12  20  E13  15  16  E14  17  6

1a  14  5  11  1b  1c  2

3

M3  M2  M1  M4  M5  M6

4

S  A  E2  4a

# FIG 2

$U_G$

+5V

0

t1  t2  t

# FIG 3

U  24

22  G

23

FIG 4